# EUROPEAN PATENT APPLICATION

(11) **EP 4 513 210 A1**
(43) Date of publication of application: **26.02.2025**
(21) Application number: 23907323.2
(22) Date of filing: 05.10.2023
(51) Int. Cl.: G01R 31/367, G01R 31/374, G01R 31/396, G01R 31/382, H01M 10/48, G01K 3/02

(54) **BATTERY OUTPUT PREDICTION METHOD, AND BATTERY SYSTEM FOR PROVIDING SAME**

(30) Priority: 23.12.2022 KR 20220183568
(71) Applicant: LG Energy Solution, Ltd., Seoul 07335 (KR)
(72) Inventor: LIM, Jaehwan, Daejeon 34122 (KR); KWON, Hyuk Chang, Daejeon 34122 (KR)
(74) Representative: Plasseraud IP
(86) International application number: PCT/KR2023/015316
(87) International publication number: WO 2024/136037

(57) **Abstract**

Provided are a method for predicting output power of a battery and a battery system providing the same, the system including: a battery including a plurality of battery modules each including a plurality of battery cells; and a main control circuit determining a representative temperature corresponding to a battery temperature based on a plurality of module temperatures which are respective temperatures of the plurality of battery modules, a cooling water temperature which is a temperature of cooling water flowing between the plurality of battery modules, and an air temperature, and predicting an output power value of the battery based on a state of charge SOC of the battery that is determined based on the determined representative temperature and a predetermined reference.

## Description

### [Technical Field]

### CROSS-REFERENCE TO RELATED APPLICATION

This application claims priority to and the benefit of Korean Patent Application No. 10-2022-0183568 filed in the Korean Intellectual Property Office on December 23, 2022, the entire contents of which are incorporated herein by reference.

The present disclosure relates to a method for predicting output power of a battery and a battery system providing the same.

### [Background Art]

One of key techniques in battery development may relate to output power of a battery when the battery is charged or discharged. In particular, the output power of the battery may be a very important factor when planning an operation of a system equipped with the battery.

A size of the output power of the battery may be closely related to a battery temperature. For example, when an external air temperature is high, the maximum cell temperature having the maximum value may be extracted among respective cell temperatures of the plurality of battery cells, and the maximum output power of the battery may be predicted based on the extracted maximum cell temperature. For another example, when the external air temperature is low, the minimum cell temperature having the minimum value may be extracted among the respective cell temperatures of the plurality of battery cells, and the maximum output power of the battery may be predicted based on the extracted minimum cell temperature.

However, a prior method of predicting the output power of the battery as described above may require a device such as a temperature sensor to be mounted on each of the plurality of battery cells to measure the cell temperature. In addition, the prior method may require a complicated process of determining the cell temperature that represents the battery temperature based on the plurality of measured cell temperatures. That is, the prior method may have burdens of cost incurred due to a purchase of the plurality of temperature sensors and a need for a separate process to determine the battery temperature.

### [Disclosure]

### [Technical Problem]

The present disclosure attempts to provide a battery system which may precisely predict output power of a battery based on cell temperatures of some battery cells among the plurality of battery cells included in the battery, and a method for predicting output power of a battery.

### [Technical method]

According to an embodiment, provided is a battery system including: a battery including a plurality of battery modules each including a plurality of battery cells; and a main control circuit determining a representative temperature corresponding to a battery temperature based on a plurality of module temperatures which are respective temperatures of the plurality of battery modules, a cooling water temperature which is a temperature of cooling water flowing between the plurality of battery modules, and an air temperature, and predicting an output power value of the battery based on a state of charge SOC of the battery that is determined based on the determined representative temperature and a predetermined reference.

The main control circuit may determine a maximum value among the plurality of module temperatures as the representative temperature when the plurality of module temperatures fall within an average temperature range corresponding to a temperature higher than a predetermined first reference temperature and lower than a predetermined second reference temperature.

The main control circuit may determine the maximum value among the plurality of module temperatures as the representative temperature when the plurality of module temperatures are outside the average temperature range, and the air temperature is the cooling water temperature or higher.

The main control circuit may determine a minimum value among the plurality of module temperatures as the representative temperature when the plurality of module temperatures are outside the average temperature range and the air temperature is lower than the cooling water temperature.

The main control circuit may correct the predicted output power value by reducing the predicted output power value based on the predetermined reference when the representative temperature falls within an extreme temperature range corresponding to a temperature lower than a minimum reference temperature which is lower than the first reference temperature by a predetermined temperature or a temperature higher than a maximum reference temperature which is higher than the second reference temperature by a predetermined temperature.

Each of the plurality of battery modules may include a reference cell which is a battery cell disposed within a predetermined range from an outlet of a cooling water plate through which the cooling water flows among the plurality of battery cells, and the module temperature of each of the plurality of battery modules may correspond to a cell temperature of the reference cell.

Each of the plurality of battery cells may be formed in a pillar shape having a bottom disposed to be close to the cooling water, a top opposing the bottom while being spaced apart from the bottom by a predetermined distance, and a side connecting the bottom with the top, and a temperature of the top may have a maximum value when the bottom is cooled, and the temperature of the top may have a minimum value when the bottom is heated.

The cell temperature of the reference cell may correspond to a temperature of the reference cell that is measured at its top.

According to another embodiment, provided is a method for predicting output power of a battery, which is the method for predicting output power of a battery including a plurality of battery modules each including a plurality of battery cells, the method including: receiving a plurality of module temperatures which are respective temperatures of the plurality of battery modules; determining a representative temperature corresponding to a battery temperature based on the plurality of module temperatures, a cooling water temperature which is a temperature of cooling water flowing between the plurality of battery modules, and an air temperature; and predicting an output power value of the battery based on a state of charge SOC of the battery that is determined based on the determined representative temperature and a predetermined reference.

The determining of the representative temperature may include: determining whether the plurality of module temperatures fall within an average temperature range corresponding to a temperature higher than a predetermined first reference temperature and lower than a predetermined second reference temperature; and determining a first temperature of determining a maximum value among the plurality of module temperatures as the representative temperature when the plurality of module temperatures fall within the average temperature range as a determination result.

The determining of the representative temperature may further include: determining whether the air temperature is lower than the cooling water temperature when the plurality of module temperatures do not fall within the average temperature range as a determination result; and determining a second temperature of determining a minimum value among the plurality of module temperatures as the representative temperature when the air temperature is lower than the cooling water temperature as the determination result, and the determining of the first temperature is performed when the air temperature is the cooling water temperature or higher as the determination result.

The method may further include: after the predicting of the output power value of the battery, determining whether the representative temperature falls within an extreme temperature range corresponding to a temperature lower than a minimum reference temperature which is lower than the first reference temperature by a predetermined temperature or a temperature higher than a maximum reference temperature which is higher than the second reference temperature by a predetermined temperature; correcting the predicted output power value by reducing the predicted output power value when the representative temperature falls within the extreme temperature range as a determination result; and confirming the predicted output power value as the output power of the battery when the representative temperature does not fall within the extreme temperature range as the determination result.

### [Advantageous Effects]

As set forth above, the present disclosure may reduce the manufacturing costs by reducing the number of temperature sensors needed to measure the battery temperature.

The present disclosure may predict the output power of the battery with the higher reliability by using the battery temperature determination process performed in consideration of the external air temperature and the cooling water temperature, even when the output power of the entire battery is predicted based on the cell temperatures of some battery cells.

### [Description of the Drawings]

FIG. 1 is a view showing a battery system according to an embodiment.
FIG. 2 is an example view showing one type of a battery cell included in a battery of FIG. 1.
FIG. 3 is an example view showing another type of the battery cell included in the battery of FIG. 1.
FIGS. 4 and 5 are views explaining a feature of a cylindrical battery cell of FIG. 2.
FIG. 6 is an example view explaining a structure of the battery of FIG. 1.
FIG. 7 is a view showing a cross-section of the battery of FIG. 6.
FIG. 8 is a view showing an example in which two battery modules included in the battery of FIG. 6 are disposed on the top and bottom of one cooling plate CP.
FIG. 9 is a view explaining a structure of the cooling plate shown in FIGS. 6 to 8.
FIGS. 10 and 11 are views explaining a temperature of a cooling water flowing in the cooling plate, an air temperature, and a temperature of the battery cell based on a position of the cooling plate.
FIGS. 12 to 15 are views showing a position of a reference cell in each of first to fourth battery modules M1, M2, M3, and M4 of FIG. 7.
FIG. 16 is a flowchart explaining a method for predicting output power of a battery according to another embodiment.
FIG. 17 is an example view explaining the maximum temperature and minimum temperature concepts of FIG. 16.

### [Mode for Invention]

Hereinafter, embodiments disclosed in the specification are described in detail with reference to the accompanying drawings, components that are the same as or similar to each other are denoted by the same or similar reference numerals, and an overlapping description thereof is omitted. Terms "module" and/or "unit" for components described in the following description are used only to make the specification easily understood. Therefore, these terms do not have meanings or roles distinguished from each other in themselves. Further, when it is decided that a detailed description for the known art related to the present disclosure may obscure the gist of the present disclosure, the detailed description will be omitted. Furthermore, it is to be understood that the accompanying drawings are provided only to allow the embodiments of the present disclosure to be easily understood, and the spirit of the present disclosure is not limited by the accompanying drawings and includes all the modifications, equivalents and substitutions included in the spirit and scope of the present disclosure.

Terms including ordinal numbers such as "first," "second" and the like, may be used to describe various components. However, these components are not limited by these terms. The terms are used only to distinguish one component from another component.

It is to be understood that when one component is referred to as being "connected to" or "coupled to" another component, one component may be directly connected to or directly coupled to another component, or may be connected to or coupled to another component while having a third component interposed therebetween. On the other hand, it is to be understood that when referred to as being "connected directly to" or "coupled directly to" another element, one element may be connected to or coupled to another element without a third element interposed therebetween.

It is to be understood that terms "include," "have" and the like used in the present application specify the presence of features, numerals, steps, operations, components, parts or combinations thereof, mentioned in the specification, and do not preclude the presence or possible addition of one or more other features, numerals, steps, operations, components, parts or combinations thereof.

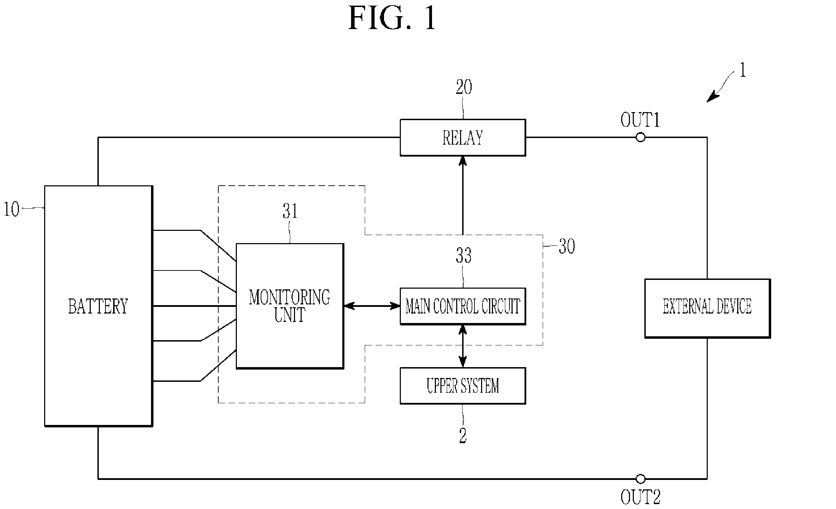

FIG. 1 is a view showing a battery system according to an embodiment.

Referring to FIG. 1, a battery system 1 may include a battery 10, a relay 20, and a battery management system (BMS) 30.

In FIG. 1, an upper system 2 may be mounted with the battery system 1, and operated by receiving power from the battery 10. For example, the upper system 2 may include an automobile system, an energy storage system (ESS), or the like.

The battery 10 may be connected between two output terminals OUT1 and OUT2 of the battery system 1, the relay 20 may be connected between a positive electrode of the battery system 1 and the first output terminal OUT1, and a current sensor (not shown) may be connected between a negative electrode of the battery system 1 and the second output terminal OUT2. The components and a connection relationship between the components, shown in FIG. 1, are examples, and the present disclosure is not limited thereto.

The battery 10 may include a plurality of battery modules M each including a plurality of battery cells Cell1 to Celln that are electrically connected in series and parallel to each other. In some examples, the battery cell may be a rechargeable secondary battery. A predetermined number of battery cells may be connected in series and/or parallel to each other to thus form the battery module, and a predetermined number of battery modules may be connected in series and/or parallel to each other to thus form the battery 10.

The relay 20 may control electrical connection between the battery system 1 and an external device. When the relay 20 is turned on, the battery system 1 and the external device may be electrically connected to each other to thus perform the charging or discharging of the battery, and when the relay 20 is turned off, the battery system 1 and the external device may be electrically disconnected from each other. Here, the external device may be a charger in a charging cycle in which the battery 10 receives power to thus be charged, and may be a load (e.g., a motor) in a discharging cycle in which the battery 10 discharges power to the external device.

The BMS 30 may include a monitoring unit 31 and a main control circuit 33.

The monitoring unit 31 may collect a plurality of module temperatures, which are temperatures of each of a plurality of battery modules M1 to Mn, and transmit the collected module temperatures to the main control circuit 33.

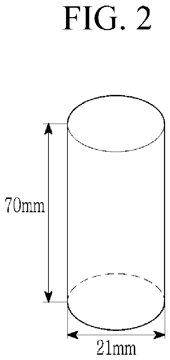

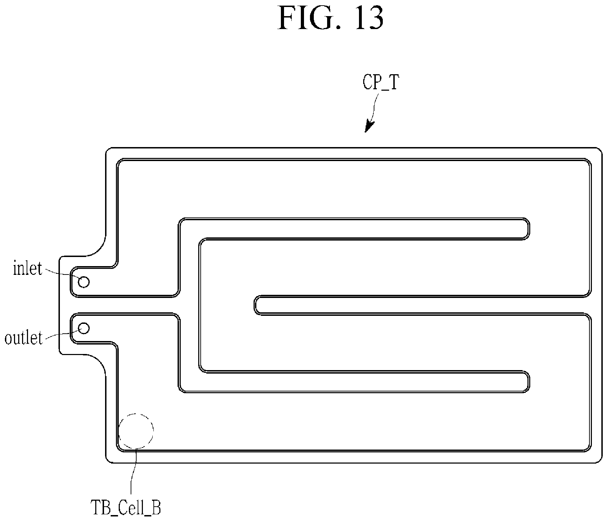

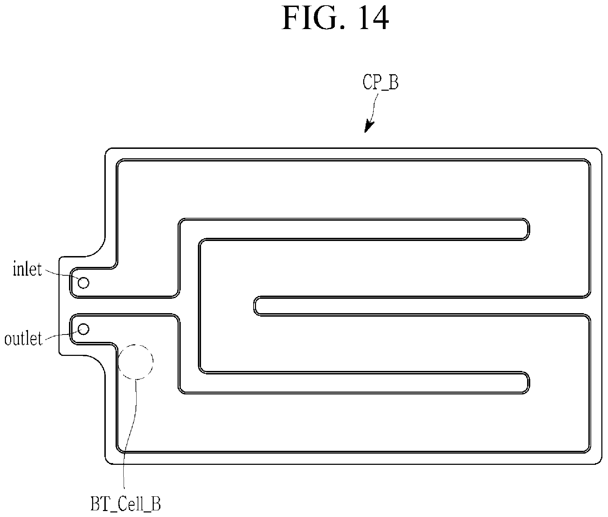

A module temperature MT may be the temperature of the battery module. In some examples, the module temperature MT may correspond to a cell temperature CT of a battery cell (hereinafter referred to as a reference cell) determined based on a predetermined reference among the plurality of battery cells Cell1 to Celln included in the battery module M. Here, a method for determining the reference cell may be described in detail with reference to FIGS. 2 to 14.

The main control circuit 33 may determine a representative temperature corresponding to a temperature of the battery 10 based on the plurality of module temperatures, a cooling water temperature, which is a temperature of cooling water flowing between the plurality of battery modules M1 to Mn, and an air temperature. In addition, the main control circuit 33 may predict output power of the battery 10 based on the representative temperature and a state of charge SOC of the battery 10. Here, the output power of the battery 10 may be charge output power or discharge output power, and may be expressed by a numerical value.

Referring to FIG. 1, for example, the main control circuit 33 may receive information on the cooling water temperature and the air temperature by communicating with the upper system 2 mounted with the battery system 1. For another example, the main control circuit 33 may directly receive the information on the cooling water temperature and the air temperature from various temperature sensors (not shown) mounted on the upper system 2. However, the present disclosure is not limited thereto, and the main control circuit 33 may collect the information on the cooling water temperature and the air temperature in various ways.

Table 1 below shows an example of a look-up table including charge output power COP of the battery 10 according to the temperature and state of charge SOC of the battery.

**[Table 1]**

| COP | **Battery temperature (°C)** | | | | | | | |
|---|---|---|---|---|---|---|---|---|
| SOC(%) | -4.5 | -35 | -15 | 0 | 10 | 25 | 45 | 55 |
| 10 | 13896 | 27313 | 40636 | 66175 | 87140 | 139307 | 144486 | 72243 |
| 25 | 27904 | 48761 | 77336 | 116163 | 132403 | 150793 | 156228 | 18114 |
| 45 | 39318 | 64823 | 100743 | 135200 | 143153 | 156439 | 161679 | 80840 |
| 60 | 51728 | 84266 | 122872 | 142430 | 150063 | 162942 | 167259 | 83630 |
| 80 | 596080 | 98496 | 134033 | 151808 | 160738 | 173427 | 177692 | 88846 |

The main control circuit 33 may predict the charge output power of the battery 10 by matching the battery temperature with the state of charge SOC of the battery in Table 1 above. In some examples, the battery temperature disclosed in Table 1 may correspond to the representative temperature calculated based on the plurality of module temperatures, the cooling water temperature, and the air temperature.

Table 2 below is an example of a look-up table including discharge output power DOP of the battery 10 based on the temperature and state of charge SOC of the battery 10.

**[Table 2]**

| DOP | **Battery temperature (°C)** | | | | | | | |
|---|---|---|---|---|---|---|---|---|
| SOC(%) | -45 | -35 | -15 | 0 | 10 | 25 | 45 | 55 |
| 10 | 32398 | 57932 | 100245 | 169645 | 217143 | 210815 | 205895 | 102948 |
| 25 | 28551 | 52097 | 90552 | 152352 | 190764 | 214983 | 210423 | 105211 |
| 45 | 23878 | 43450 | 78501 | 137437 | 171716 | 218730 | 213807 | 106904 |
| 60 | 17487 | 32678 | 59315 | 103095 | 128652 | 218423 | 220 698 | 110348 |
| 80 | 6385 | 13134 | 25158 | 45317 | 68421 | 124432 | 151673 | 75837 |

The main control circuit 33 may predict the discharge output power of the battery 10 by matching the temperature of the battery 10 with its state of charge SOC in Table 2. In some examples, the battery temperature disclosed in Table 2 above may correspond to the representative temperature calculated based on the plurality of module temperatures, the cooling water temperature, and the air temperature.

In a prior art, there is a need for the number of temperature sensors corresponding to a total number of battery cells included in the battery 10 in order to collect the temperature of the battery 10. In addition, the prior BMS 30 may perform a complex process of determining the temperature of the battery 10 based on the measured cell temperatures of all the battery cells.

In some examples, the monitoring unit 31 may measure only the cell temperature CT of the reference cell representing the battery module M, and determine the measured cell temperature CT as the module temperature MT. In addition, the main control circuit 33 may perform a simple process of determining one of the respective module temperatures MT of the plurality of battery modules included in the battery 10 as the representative temperature which is the temperature of the battery 10. The main control circuit 33 may then determine the temperature of the battery 10 by using only the number of temperature sensors corresponding to the number of battery modules M.

Hereinafter, the description describes in detail the method for determining the reference cell representing the battery module M based on the structural and positional features of the battery cell.

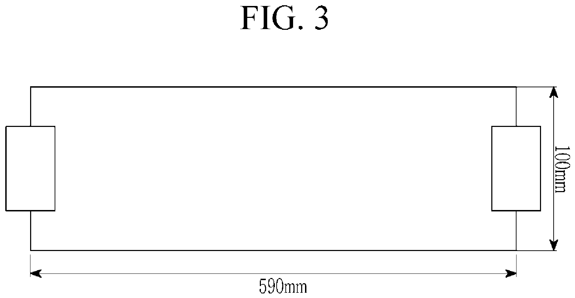

FIG. 2 is an example view showing one type of the battery cell included in the battery of FIG. 1; FIG. 3 is an example view showing another type of the battery cell included in the battery of FIG. 1; and FIGS. 4 and 5 are views explaining a feature of a cylindrical battery cell of FIG. 2.

Referring to FIG. 2, as an example, the battery cell may have a small cylindrical shape. For example, specifications of the cylindrical battery cell used for an electric vehicle may adopt 21 mm as a diameter of its top and bottom and 70mm as its height. Referring to FIG. 3, as another example, the battery cell may have a large pouch shape. For example, specifications of the pouch-type battery cell used for the electric vehicle may adopt a horizontal length of 590mm and a vertical length of 100mm.

Referring to FIGS. 2 and 3, compared to the pouch-type battery cell, a cross-section of the cylindrical battery cell that is heated or cooled may be very small, and a temperature distribution in the cross-section may thus be almost the same. In addition, the cylindrical battery cell may have a constant temperature change based on its height.

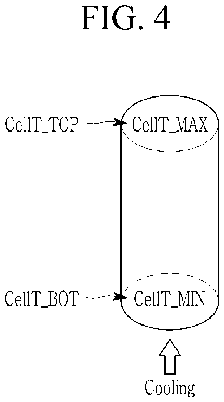

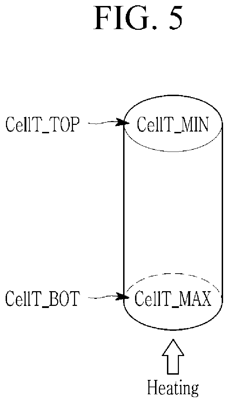

Referring to FIG. 4, for example, when a bottom Cell_BOT of the cylindrical battery cell of FIG. 2 is cooled, a temperature of its top Cell_TOP may be the highest Cell_MAX among all surfaces included in the battery cell. Referring to FIG. 5, for another example, when the bottom Cell_BOT of the cylindrical battery cell of FIG. 2 is heated, the temperature of the top Cell_TOP may be the lowest Cell_MIN among all the surfaces included in the battery cell.

In some examples, the battery cell included in the battery 10 and the battery module may be the cylindrical battery cell described with reference to FIGS. 2, 4, and 5. In some examples, the battery cell may be formed in a pillar shape having the bottom Cell_BOT disposed to be close to the cooling water, the top Cell_TOP opposing the bottom Cell_BOT while being spaced apart from the bottom by a predetermined distance, and a side Cell_SIDE connecting the bottom Cell_BOT with the top Cell_TOP. However, the present disclosure is not limited thereto, and the battery cell may form the battery 10 regardless of its shape when the battery cell has the temperature of the top Cell_TOP which is the highest when the bottom Cell_BOT is cooled, and the temperature of the top Cell_TOP which is the lowest when the bottom Cell_BOT is heated.

Hereinafter, the description describes in detail a structure of the battery 10, which includes the plurality of battery modules including the plurality of battery cells.

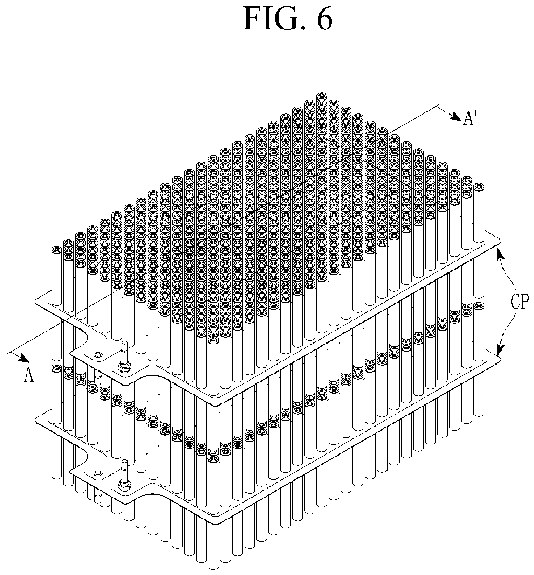

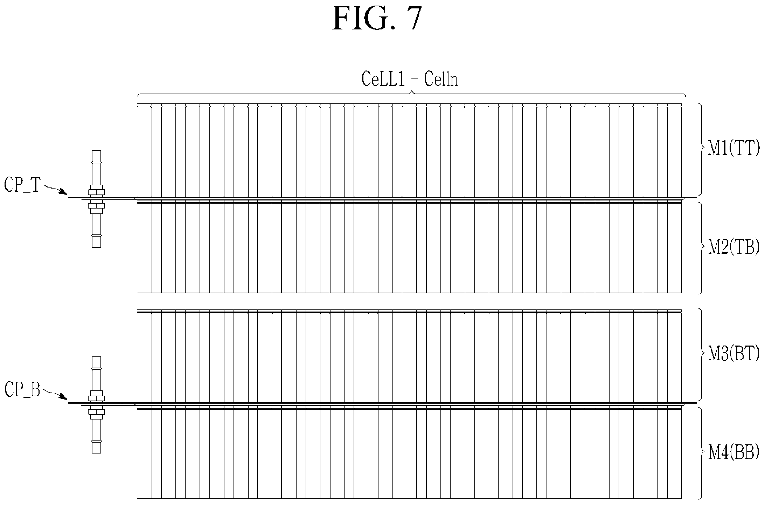

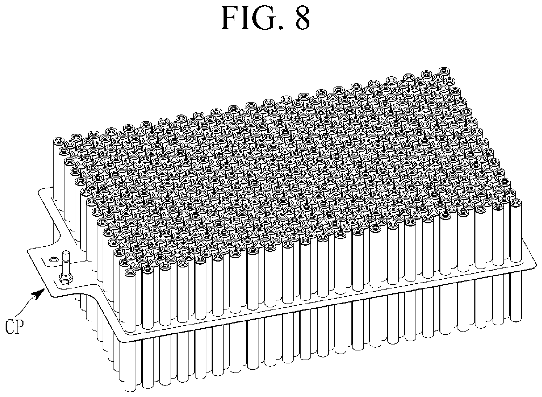

FIG. 6 is an example view explaining the structure of the battery of FIG. 1; FIG. 7 is a view showing a cross-section of the battery of FIG. 6; and FIG. 8 is a view showing an example in which two battery modules included in the battery of FIG. 6 are disposed on the top and bottom of one cooling plate CP.

The battery 10 may include at least one battery pack including the plurality of battery modules M each including the plurality of battery cells Cell1 to Celln. For example, the battery 10 may include at least one battery pack shown in FIG. 6. Hereinafter, the battery 10 is described as including one battery pack, the present disclosure is not limited thereto, and the battery 10 may include the plurality of battery packs shown in FIG. 6. In this case, the number of module temperatures required for a method of calculating the representative temperature, which is described below, may be increased. However, a basic calculation method may be equally applied thereto.

Referring to FIGS. 6 and 7, for example, the battery 10 may include the four battery modules M1, M2, M3, and M4 disposed on the top and bottom of each of two cooling plates CP_T and CP_B, and each of the four battery modules M1, M2, M3, and M4 may include the plurality of battery cells Cell1 to Celln connected in parallel with each other.

The cooling plate CP may be a plate through which the cooling water flows as a liquid that cools heat of the battery cell. In some examples, the battery 10 may include the two cooling plates CPs, and may be distinguished into the upper cooling plate CP_T and the lower cooling plate CP_B based on their positions. Referring to FIGS. 6 and 7, the first battery module M1 may be disposed on a top TT of the upper cooling plate CP_T, and the second battery module M2 may be disposed on a bottom TB of the upper cooling plate CP_T. Here, the bottom Cell_BOT of each of the plurality of battery cells included in each of the first battery module M1 and the second battery module M2 may all be disposed to be close to or in contact with the upper cooling plate CP_T. In addition, the third battery module M3 may be disposed on a top BT of the lower cooling plate CP_B, and the fourth battery module M4 may be disposed on a bottom BB of the lower cooling plate CP_B. Here, the bottom Cell_BOT of each of the plurality of battery cells included in each of the third battery module M3 and the fourth battery module M4 may all be disposed to be close to or in contact with the lower cooling plate CP_B. Referring to FIG. 8, the upper cooling plate CP_T and the lower cooling plate CP_B may respectively have the battery modules disposed on the top and bottom of the cooling plate CP.

Hereinafter, the description describes in detail the method for determining the reference cell representing the battery module M based on the positional feature of the battery cell.

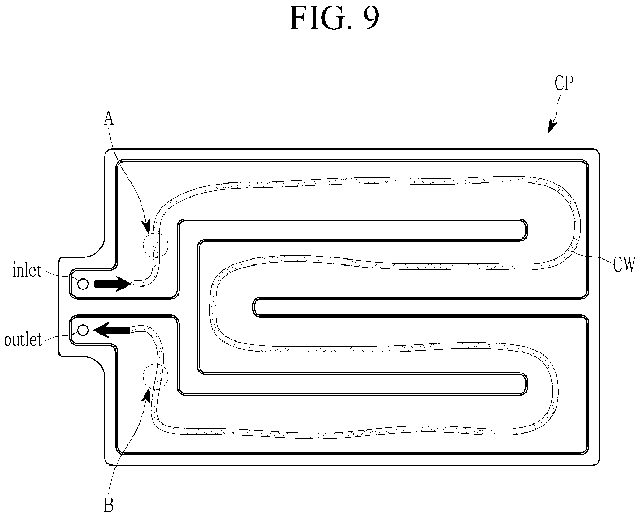

FIG. 9 is a view explaining the structure of the cooling plate shown in FIGS. 6 to 8; and FIGS. 10 and 11 are views explaining the temperature of the cooling water flowing in the cooling plate, the air temperature, and the temperature of the battery cell based on the position of the cooling plate.

Referring to FIG. 9, the cooling plate CP may include an inlet through which cooling water CW is introduced and an outlet through which the cooling water is discharged. In addition, a flow path may be formed in the cooling plate CP by a plurality of partition walls. The cooling water CW may flow along the flow path and exchange heat with the plurality of battery cells in contact with the cooling plate CP. That is, the cooling water CW may absorb heat of the plurality of battery cells to lower the temperature of the plurality of battery cells. Therefore, as the cooling water CW flows along the flow path, the temperature of the cooling water CW may be gradually increased. In summary, the temperature of the cooling water CW may be lowest at a position A close to the inlet and highest at a position B close to the outlet. Hereinafter, the temperature of the cooling water CW is described as the cooling water temperature.

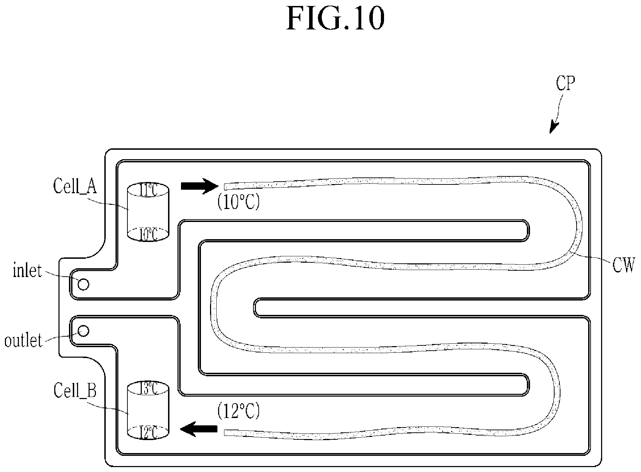

Referring to FIG. 10, for example, it is assumed that the air temperature is 25°C, the cooling water temperature is 10°C, and the temperature of the battery cell corresponds to the air temperature. In this environment, referring to FIGS. 6 and 8, the cooling water CW may be heated by an atmosphere while the cooling water CW flows along the flow path. That is, the temperature of the cooling water CW may be gradually increased as the movement time and/or movement distance of the cooling water CW is increased. For example, the cooling water temperature at the outlet may be 12°C, 13°C, 14°C, or the like when the cooling water temperature at the inlet is 10°C. As shown in FIG. 10, it is assumed that the cooling water temperature at its position close to the outlet is 12°C.

As shown in FIG. 10, the temperature of the battery cell may be higher than the cooling water temperature, the bottom of the battery cell may thus be cooled by the cooling water CW. In addition, the bottom of the battery cell may be disposed to be in contact with (or close to) the cooling plate CP, and a temperature of the bottom of the battery cell may be the same as the cooling water temperature within a predetermined error range. For example, a bottom of a battery cell Cell_A at the position A close to the inlet may be cooled by the cooling water, and eventually a temperature of the bottom of the battery cell Cell_A may be 10°C, which is the same as the cooling water temperature of 10°C. The bottom of a battery cell Cell_B at the position B close to the outlet may be cooled by the cooling water, and eventually a temperature of the bottom of the battery cell Cell_B may be 12°C, which is the same as the cooling water temperature of 12°C. As described above with reference to FIG. 4, the temperature of the top may be higher than the temperature of the bottom when the bottom is cooled. For example, assuming that a temperature difference between the top and bottom is about 1 °C based on the feature of the battery cell, a temperature of the top of the battery cell Cell_A may be about 11°C, and a temperature of the top of the battery cell Cell_B may be about 13°C.

To summarize the case of FIG. 10, the temperature of the battery cell Cell_B disposed to be close to the outlet may be the highest among the plurality of battery cells in contact with (or close to) the cooling plate CP when the air temperature is higher than the cooling water temperature. In particular, the temperature of the top of the battery cell Cell_B may be the highest.

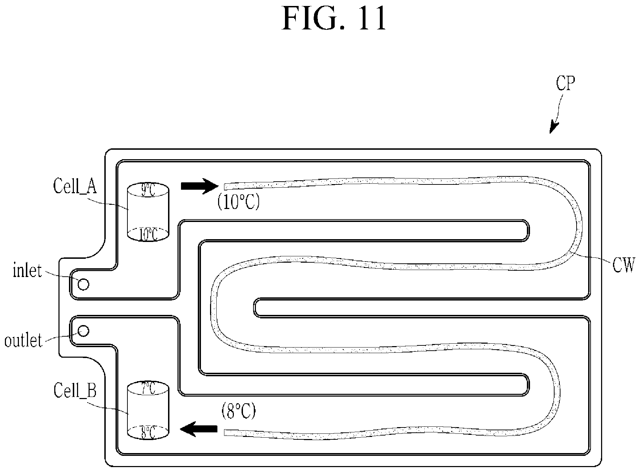

Referring to FIG. 11, for example, it is assumed that the air temperature is 5°C, the cooling water temperature is 10°C, and the temperature of the battery cell corresponds to the air temperature. In this environment, referring to FIGS. 6 and 8, the cooling water CW may be cooled by the atmosphere while the cooling water CW flows along the flow path. That is, the temperature of the cooling water CW may be gradually decreased as the movement time and/or movement distance of the cooling water CW is increased. For example, the cooling water temperature at the inlet may be 8°C, 7°C, 6°C, or the like when the cooling water temperature at the inlet is 10°C. As shown in FIG. 11, it is assumed that the cooling water temperature at its position close to the outlet is 8°C.

As shown in FIG. 11, the temperature of the battery cell may be lower than the cooling water temperature, the bottom of the battery cell may thus be heated by the cooling water CW. In addition, the bottom of the battery cell may be disposed to be in contact with (or close to) the cooling plate CP, and the temperature of the bottom of the battery cell may be the same as the cooling water temperature within the predetermined error range. For example, the temperature of the bottom of the battery cell Cell_A at the position A close to the inlet may be 10°C, which is the same as the cooling water temperature of 10°C. The temperature of the bottom of the battery cell Cell_B at the position B close to the outlet may be 8°C, which is the same as the cooling water temperature of 8°C. As described above with reference to FIG. 5, the temperature of the top may be lower than the temperature of the bottom when the bottom is heated. For example, assuming that the temperature difference between the top and bottom is about 1 °C based on the feature of the battery cell, the temperature of the top of the battery cell Cell_A may be about 9°C, and the temperature of the top of the battery cell Cell_B may be about 7°C.

To summarize the case of FIG. 11, the temperature of the battery cell Cell_B disposed to be close to the outlet may be the lowest among the plurality of battery cells in contact with (or close to) the cooling plate CP when the air temperature is lower than the cooling water temperature. In particular, the temperature of the top of the battery cell Cell_B may be the lowest.

In summary, the temperature of the battery cell Cell_B disposed to be close to the outlet of the cooling plate CP may be the highest among the plurality of battery cells included in the battery module when the air temperature is higher than the cooling water temperature. In addition, the temperature of the battery cell Cell_B disposed to be close to the outlet of the cooling plate CP may be the lowest among the plurality of battery cells included in the battery module when the air temperature is lower than the cooling water temperature. That is, when the air temperature and the cooling water temperature are known, it is possible to predict the maximum or minimum temperature in the battery module by using only the temperature of the battery cell Cell_B disposed to be close to the outlet of the cooling plate CP. A method for predicting the maximum or minimum temperature in the battery module may be equally applied to the plurality of battery modules M1, M2, M3, and M4 included in the battery pack.

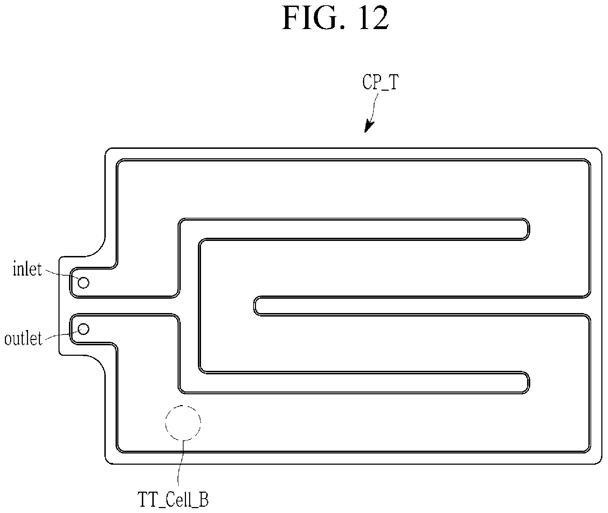

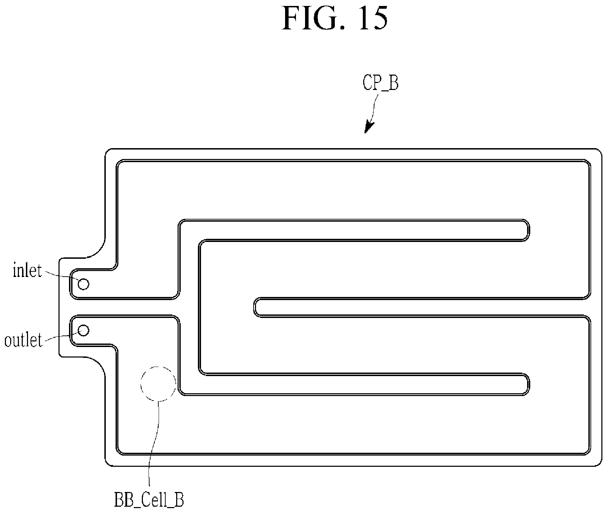

FIGS. 12 to 15 are views showing a position of the reference cell in each of the first to fourth battery modules M1, M2, M3, and M4 of FIG. 7.

As described above with reference to FIGS. 4 to 11, the maximum or minimum temperature in the battery module may be predicted only based on the temperature of the battery cell Cell_B disposed to be close to the outlet of the cooling plate CP.

In some examples, the battery cell Cell_B disposed to be close to the outlet of the cooling plate CP in each of the plurality of battery modules M1, M2, M3, and M4 may be defined as the reference cell representing the battery module. That is, the reference cell may be a battery cell disposed within a predetermined distance from the outlet of the cooling plate CP among the plurality of battery cells included in the battery module.

Referring to FIGS. 6, 7, and 12, a reference cell TT_Cell_B of the first battery module M1 may be disposed to be close to the outlet of the cooling plate CP at the top TT of the upper cooling plate CP_T. Referring to FIGS. 6, 7, and 13, a reference cell TB_Cell_B of the second battery module M2 may be disposed to be close to the outlet of the cooling plate CP at the bottom TB of the upper cooling plate CP_T. Referring to FIGS. 6, 7, and 14, a reference cell BT_Cell_B of the third battery module M3 may be disposed to be close to the outlet of the cooling plate CP at the top BT of the lower cooling plate CP_B.

Referring to FIGS. 6, 7, and 15, a reference cell BB_Cell_B of the fourth battery module M4 may be disposed to be close to the outlet of the cooling plate CP at the bottom BB of the lower cooling plate CP_B.

In some examples, the module temperature of each of the plurality of battery modules M1, M2, M3, and M4 may correspond to the temperature of each reference cell. In some other examples, the module temperature of each of the plurality of battery modules M1, M2, M3, and M4 may correspond to the temperature of each reference cell measured at the top.

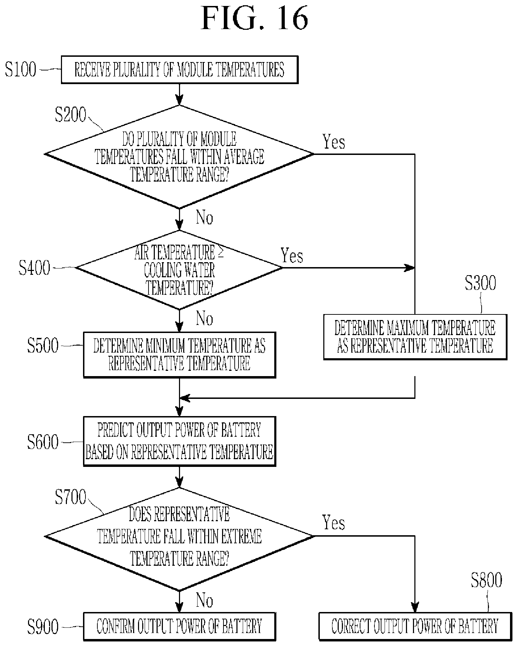

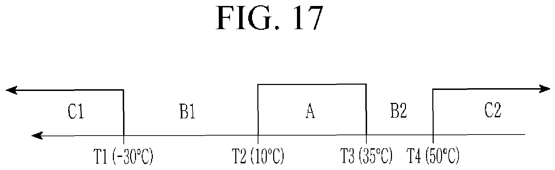

FIG. 16 is a flowchart explaining a method for predicting output power of a battery according to another embodiment; and FIG. 17 is an example view explaining the maximum temperature and minimum temperature concepts of FIG. 16.

Referring to FIGS. 1 to 17, the description describes the method for predicting output power of a battery and the battery system providing the same.

Referring to FIG. 16, a main control circuit 33 may first receive, from a monitoring unit 31, information on a plurality of module temperatures which are respective temperatures of a plurality of battery modules M1, M2, M3, and M4 (S100).

The monitoring unit 31 may collect the plurality of module temperatures and transmit the information on the collected plurality of module temperatures to the main control circuit 33. A module temperature MT may be the temperature of the battery module. In some examples, the module temperature MT may correspond to a cell temperature CT of a reference cell among a plurality of battery cells Cell1 to Celln included in a battery module M.

Next, the main control circuit 33 may determine whether the plurality of module temperatures fall within an average temperature range (S200).

The average temperature range may be a temperature range within which a battery 10 may be operated normally within a predicted range according to a predetermined process. In some examples, the average temperature range may be defined as a temperature range corresponding to a temperature higher than a predetermined first reference temperature and lower than a predetermined second reference temperature. Referring to FIG. 17, for example, a first reference temperature T2 may be 10°C, and a second reference temperature T3 may be 35°C. However, the present disclosure is not limited thereto, and the first reference temperature T2 and the second reference temperature T3 may be determined in consideration of various situations such as a structure of the battery 10.

Next, as a result of the determination, when the plurality of module temperatures fall within the average temperature range as a determination result (YES in S200), the main control circuit 33 may determine, as a representative temperature, the maximum temperature among the plurality of module temperatures (that is, a step of determining a first representative temperature) (S300).

When the plurality of module temperatures fall within the average temperature range, the main control circuit 33 may determine, as the representative temperature, the maximum temperature among the plurality of module temperatures. When any of the plurality of module temperatures does not fall within the average temperature range, the main control circuit 33 may execute a step S400 below.

Next, when at least one module temperature does not fall within the average temperature range as the determination result (NO in S200), the main control circuit 33 may determine whether an air temperature is the cooling water temperature or higher (S400).

For example, the main control circuit 33 may receive information on a cooling water temperature and the air temperature by communicating with an upper system 2 mounted with a battery system 1. For another example, the main control circuit 33 may directly receive the information on the cooling water temperature and the air temperature from various temperature sensors (not shown) mounted on the upper system 2. However, the present disclosure is not limited thereto, and the main control circuit 33 may collect the information on the cooling water temperature and the air temperature in various ways.

Next, when the air temperature is the cooling water temperature or higher as a determination result (YES in S400), the main control circuit 33 may determine, as the representative temperature, the maximum temperature which has the maximum value among the plurality of module temperatures (S300).

In some examples, the representative temperature may be a temperature corresponding to a temperature of the battery 10. In the prior art, the respective cell temperatures of all the battery cells included in the battery 10 may be collected, and the maximum or minimum temperature among the temperatures may be determined as the temperature of the battery 10. However, in some examples, the main control circuit 33 may collect only the module temperatures of the plurality of battery modules included in the battery 10, and determine one of the module temperatures as the temperature of the battery 10. Therefore, according to the battery system and the method for predicting output power of a battery according to the embodiments, it is possible to significantly reduce the number of temperature sensors compared to those in the prior art.

Next, when the air temperature is lower than the cooling water temperature as the determination result (NO in S400), the main control circuit 33 may determine, as the representative temperature, the minimum temperature which has the minimum value among the plurality of module temperatures (that is, a step of determining a second representative temperature)(S500).

Next, the main control circuit 33 may predict output power of the battery 10 based on the representative temperature and a state of charge SOC of the battery 10 (S600).

The main control circuit 33 may predict the output power of the battery 10 according to various known algorithms based on the representative temperature and the state of charge SOC of the battery 10. For example, the main control circuit 33 may predict the output power of the battery 10 by matching the representative temperature with the state of charge SOC of the battery 10 in a look-up table.

Referring to Table 1, the main control circuit 33 may predict charge output power of the battery 10 by matching the representative temperature with the state of charge SOC of the battery 10 in the look-up table. For example, it is assumed that the representative temperature is 25°C and the state of charge SOC of the battery 10 is 60%. The main control circuit 33 may then predict the charge output power of the battery 10 as 162,942 W.

Referring to Table 2, the main control circuit 33 may predict discharge output power of the battery 10 by matching the representative temperature with the state of charge SOC of the battery 10 in the look-up table. For example, it is assumed that the representative temperature is 25°C and the state of charge SOC of the battery 10 is 60%. The main control circuit 33 may then predict the charge output power of the battery 10 as 218,423 W.

Next, the main control circuit 33 may determine whether the representative temperature falls within an extreme temperature range (S700).

The extreme temperature range may be a temperature range that makes it difficult for the battery 10 to be operated normally as the temperature of the battery 10 falls outside the predicted range according to the predetermined process. In some examples, the extreme temperature range may be a temperature range corresponding to a temperature lower than a minimum reference temperature T1, which is lower than the first reference temperature T2 by a predetermined temperature. In some other examples, the extreme temperature range may be a temperature range corresponding to a temperature higher than a maximum reference temperature T4, which is higher than the second reference temperature T3 by a predetermined temperature. Referring to FIG. 17, for example, the minimum reference temperature T1 may be -30°C, and the maximum reference temperature T4 may be 50°C. However, the present disclosure is not limited thereto, and the minimum reference temperature T1 and the maximum reference temperature T4 may be determined in consideration of various situations such as the structure of the battery 10.

Next, when the representative temperature falls within the extreme temperature range as a determination result (YES in S700), the main control circuit 33 may correct the output power of the battery 10 that is predicted in a step S600 (S800).

In some examples, the main control circuit 33 may perform the correction to reduce the output power of the battery 10 that is predicted in the step S600. The main control circuit 33 may correct the output power of the battery 10 by multiplying the predicted output power of the battery 10 by a correction ratio α defined as an integer less than 1.

Referring to Table 1, it is assumed that the representative temperature is -45°C and the state of charge SOC of the battery 10 is 60%. The main control circuit 33 may then predict the charge output power of the battery 10 as 51,728 W. In addition, it is assumed that the representative temperature of -45°C falls within the extreme temperature range (lower than -30°C and higher than 50°C) and the correction ratio α is 0.5. The main control circuit 33 may then perform the correction to reduce the output power of the battery 10 by multiplying the predicted charge output power of 51,728 W by the correction ratio of 0.5. Here, the main control circuit 33 may determine the corrected output power of the battery 10 of 51,728 x 0.5 = 25,864 W as final output power of the battery 10.

Referring to Table 2, it is assumed that the representative temperature is 55°C and the state of charge SOC of the battery 10 is 60%. The main control circuit 33 may then predict the charge output power of the battery 10 as 110,348 W. In addition, it is assumed that the representative temperature of 55°C falls within the extreme temperature range (lower than -30°C and higher than 50°C) and the correction ratio α is 0.5. The main control circuit 33 may then perform the correction to reduce the output power of the battery 10 by multiplying the predicted charge output power of 110,348 W by the correction ratio of 0.5. Here, the main control circuit 33 may determine the corrected output power of the battery 10 of 110,348 x 0.5 = 55,174 W as the final output power of the battery 10.

Next, when the representative temperature does not fall within the extreme temperature range as the determination result (NO in S700), the main control circuit 33 may finally confirm the output power of the battery 10 predicted in the step S600 as the output power of the battery 10 (S900).

Although the embodiments of the present disclosure have been described in detail hereinabove, the scope of the present disclosure is not limited thereto. Various modifications and improvements made by those skilled in the art to which the present disclosure pertains also belong to the scope of the present disclosure.

## Claims

1. A battery system comprising:
a battery including a plurality of battery modules each including a plurality of battery cells; and
a main control circuit determining a representative temperature corresponding to a battery temperature based on a plurality of module temperatures which are respective temperatures of the plurality of battery modules, a cooling water temperature which is a temperature of cooling water flowing between the plurality of battery modules, and an air temperature, and
predicting an output power value of the battery based on a state of charge SOC of the battery that is determined based on the determined representative temperature and a predetermined reference.

2. The system of claim 1, wherein
the main control circuit determines
a maximum value among the plurality of module temperatures as the representative temperature when the plurality of module temperatures fall within an average temperature range corresponding to a temperature higher than a predetermined first reference temperature and lower than a predetermined second reference temperature.

3. The system of claim 2, wherein
the main control circuit determines
the maximum value among the plurality of module temperatures as the representative temperature when the plurality of module temperatures are outside the average temperature range, and the air temperature is the cooling water temperature or higher.

4. The system of claim 2, wherein
the main control circuit determines
a minimum value among the plurality of module temperatures as the representative temperature when the plurality of module temperatures are outside the average temperature range and the air temperature is lower than the cooling water temperature.

5. The system of claim 2, wherein
the main control circuit corrects
the predicted output power value by reducing the predicted output power value based on the predetermined reference when the representative temperature falls within an extreme temperature range corresponding to a temperature lower than a minimum reference temperature which is lower than the first reference temperature by a predetermined temperature or a temperature higher than a maximum reference temperature which is higher than the second reference temperature by a predetermined temperature.

6. The system of claim 1, wherein
each of the plurality of battery modules includes
a reference cell which is a battery cell disposed within a predetermined range from an outlet of a cooling water plate through which the cooling water flows among the plurality of battery cells, and
the module temperature of each of the plurality of battery modules corresponds to
a cell temperature of the reference cell.

7. The system of claim 6, wherein
each of the plurality of battery cells is
formed in a pillar shape having a bottom disposed to be close to the cooling water, a top opposing the bottom while being spaced apart from the bottom by a predetermined distance, and a side connecting the bottom with the top, and
a temperature of the top has a maximum value when the bottom is cooled, and the temperature of the top has a minimum value when the bottom is heated.

8. The system of claim 7, wherein
the cell temperature of the reference cell corresponds to
a temperature of the reference cell that is measured at its top.

9. A method for predicting output power of a battery including a plurality of battery modules each including a plurality of battery cells, the method comprising:
receiving a plurality of module temperatures which are respective temperatures of the plurality of battery modules;
determining a representative temperature corresponding to a battery temperature based on the plurality of module temperatures, a cooling water temperature which is a temperature of cooling water flowing between the plurality of battery modules, and an air temperature; and
predicting an output power value of the battery based on a state of charge SOC of the battery that is determined based on the determined representative temperature and a predetermined reference.

10. The method of claim 9, wherein
the determining of the representative temperature includes:
determining whether the plurality of module temperatures fall within an average temperature range corresponding to a temperature higher than a predetermined first reference temperature and lower than a predetermined second reference temperature; and
determining a first temperature of determining a maximum value among the plurality of module temperatures as the representative temperature when the plurality of module temperatures fall within the average temperature range as a determination result.

11. The method of claim 10, wherein
the determining of the representative temperature further includes:
determining whether the air temperature is lower than the cooling water temperature when the plurality of module temperatures do not fall within the average temperature range as the determination result; and
determining a second temperature of determining a minimum value among the plurality of module temperatures as the representative temperature when the air temperature is lower than the cooling water temperature as a determination result, and
the determining of the first temperature is performed when the air temperature is the cooling water temperature or higher as the determination result.

12. The method of claim 10, further comprising:
after the predicting of the output power value of the battery,
determining whether the representative temperature falls within an extreme temperature range corresponding to a temperature lower than a minimum reference temperature which is lower than the first reference temperature by a predetermined temperature or a temperature higher than a maximum reference temperature which is higher than the second reference temperature by a predetermined temperature;
correcting the predicted output power value by reducing the predicted output power value when the representative temperature falls within the extreme temperature range as a determination result; and
confirming the predicted output power value as the output power of the battery when the representative temperature does not fall within the extreme temperature range as the determination result.
